# EUROPEAN PATENT SPECIFICATION

(11) **EP 3 220 120 B1**
(45) Date of publication and mention of the grant of the patent: **28.04.2021**
(21) Application number: 16160834.4
(22) Date of filing: 17.03.2016
(51) Int. Cl.: G01M 7/00, G01H 1/00, G01R 31/34

(54) **METHOD, DIAGNOSTIC DEVICE AND SYSTEM FOR DETERMINING FAULT CONDITIONS IN AN ELECTRICAL MACHINE**
VERFAHREN, DIAGNOSTISCHE VORRICHTUNG UND SYSTEM ZUR BESTIMMUNG VON FEHLERZUSTÄNDEN IN EINER ELEKTRISCHEN MASCHINE
PROCÉDÉ, DISPOSITIF ET SYSTÈME DE DIAGNOSTIC PERMETTANT DE DÉTERMINER DES ÉTATS DÉFECTUEUX DANS UNE MACHINE ÉLECTRIQUE

(43) Date of publication of application: 20.09.2017
(73) Proprietor: ABB Schweiz AG, 5400 Baden (CH)
(72) Inventor: RODRIGUEZ, Pedro, 722 25 Västerås (SE); SAHOO, Subrat, 722 19 Västerås (SE); SOULARD, Juliette, 186 53 Vallentuna (SE); LI, Ziwei, 168 74 Bromma (SE)
(74) Representative: Kransell & Wennborg KB

(56) References cited:
- WO-A1-2011/006528
- CN-B- 103 148 928
- US-A- 6 046 602
- US-A1- 2014 109 679
- US-A1- 2014 174 185
- US-A1- 2015 022 132
- FAIZ J ET AL: "Different indexes for eccentricity faults diagnosis in three-phase squirrel-cage induction motors: A review", MECHATRONICS, PERGAMON PRESS, OXFORD, GB, vol. 19, no. 1, 1 February 2009 (2009-02-01), pages 2-13, XP025804102, ISSN: 0957-4158, DOI: 10.1016/J.MECHATRONICS.2008.07.004 [retrieved on 2008-09-20]
- David G Dorrell ET AL: "Analysis of airgap flux, current, and vibration signals as a function of the combination of static and dynamic airgap eccentricity in 3-phase induction motors", IEEE TRANSACTIONS ON INDUSTRY APPLICATIONS, 1 January 1997 (1997-01-01), XP055297262, Retrieved from the Internet: URL:http://ieeexplore.ieee.org/ielx1/28/12 303/00567073.pdf?tp=&arnumber=567073&isnum ber=12303 [retrieved on 2016-08-24]
- SASIC M ET AL: "Requirements for fiber optic sensors for stator endwinding vibration monitoring", CONDITION MONITORING AND DIAGNOSIS (CMD), 2012 INTERNATIONAL CONFERENCE ON, IEEE, 23 September 2012 (2012-09-23), pages 118-121, XP032312751, DOI: 10.1109/CMD.2012.6416365 ISBN: 978-1-4673-1019-2

## Description

### TECHNICAL FIELD

The present disclosure generally relates to electrical machines. In particular, it relates to fault condition diagnostics of an electrical machine.

### BACKGROUND

Stator end winding vibrations have been a major concern for large turbine-generator windings, exceeding 50 MW, for the last 50 years. High vibrations in the end winding region that exceeds predefined acceptable limits can cause irreparable damage to the winding structure as a whole. Continuous relative motion in the support structure of the end winding results in wear and tear of the insulation layers. Once such damage exceeds the fatigue limit, turn-to-turn short circuits within the phases or inter-phase might occur. The effects in certain instances could be catastrophic, risking adverse economic impact due to unscheduled down time as well as repair.

End winding vibration becomes severe when the excitation forces acting on it, reach a resonance phenomenon with the natural frequencies of the end winding structure. The common practice of keeping track of the vibration levels is by installing accelerometers at both ends of the stator and monitoring at least one bar per phase in the radial axis of vibration. The cause for this resonance can be classified in two major ways, namely due to the manufacturing inaccuracies, continuously affecting the performance due to the operational changes and ageing. Secondly, due to the excitation forces applied on the end winding structure, coming from stator core vibrations as well as Lorentz forces on the stator bars, induced by the alternating current, in the end winding region itself. The excitation forces affect the mode shapes, whereas the natural frequencies of the winding structure alter due to mechanical ageing, thermal expansion and operational variations. US20140109679A1, WO201106528A1, US20140174185A1 and Sasic et al: "Requirements for fiber optic sensors for stator endwinding vibration monitoring", 2012 IEEE International Conference on Condition Monitoring and Diagnosis, 2012-09-23, pages 118-121, disclose methods for detecting faults in electrical machines on the basis of mechanical vibration measurements.

### SUMMARY

During the healthy state of the electrical machine, the excitation frequencies and amplitudes are within the safety limits prescribed by the original equipment manufacturers. The resonance conditions remain far from the operating frequency range of interest. However, due to operational conditions as well as thermal and mechanical ageing, the structural asymmetry starts growing. This could result in bowing or eccentric conditions of the rotor arrangement, thus affecting the existing magnetic pull. The conditions might further aggravate due to short circuit condition in the power line plus gradual or instant partial short circuit condition of stator or rotor. The modified fault conditions of the electrical machine thereby developed has the ability to alter the mode shape and natural frequency from the existing healthy condition. Such abnormality sometimes disturbs the vibration levels well above the prescribed limits, justifying actions. Additionally, the end-winding region might experience a rubbing of insulation from increased vibration levels due to the current carrying bars themselves due to phase unbalance, earth faults etc., inconsistent loading patterns, loose block between copper bars, ageing, fatigue and cracking etc.

In either of the above situations, it is important to understand the source of the vibration by clearly dissociating the signatures from their respective origins, which has not been attempted in the past. End winding vibration in synchronous machines has until now been looked at as an after-effect of the excitation forces. They are never looked at independently as contributions from active shaft lengths as well as from forces acting on the non-active length separately.

The present inventors have realised that active shaft region faults can be determined by measuring end winding vibrations. Such an effort can alleviate the maintenance preparedness, prevent unscheduled outage and offer preventive diagnostics.

In view of the above, an object of the present disclosure is to provide a method of determining fault conditions in an electrical machine, which solves or at least mitigates the problems of the prior art.

There is hence according to a first aspect of the present disclosure provided a method of determining fault conditions in a rotating electrical machine comprising a rotor and a stator by means of end winding vibration measurements, wherein the method comprises: obtaining a vibration measurement from an end winding sensor arranged on an end winding of the stator of the electrical machine, and configured to measure vibrations of the end winding, frequency transforming the vibration measurement to obtain a frequency spectrum of the vibration measurement, comparing the frequency spectrum with reference frequency spectra, and determining whether a fault condition is present in an active shaft region of the electrical machine based on the comparison between the frequency spectrum and the reference frequency spectra.

Previously, condition monitoring of the active parts of electrical machines have been performed with sensors provided inside the stator slot housing or on the rotor. The accessibility of stator bars on the end winding is easier compared to that of the active shaft length. Moreover, many large turbo generators are already equipped with these sensors, which could by means of the present invention be exploited for effective fault diagnostics. Location-wise the end winding offers improved detectability compared to installing sensors on the stator body at different axial length from drive end to non-drive end. This is due to the fact that end-winding offers reduced stiffness, compared to the stator winding parts in the active shaft region. Additionally, positioning of vibration sensors along the axial length measures the vibration for that particular region, whereas sensors in the end winding sees a vibration of the active shaft length that is transferred into the end winding.

According to one embodiment the reference frequency spectra includes reference fault frequency spectra related to faults in the active shaft region of the electrical machine, wherein the determining involves identifying the type of fault based on a match with a reference frequency spectrum of a particular fault condition. Hereto, each reference fault frequency spectrum has a signature frequency spectrum that is characteristic for a specific active shaft region fault. It should however be noted, that this may not always be sufficient to determine the specific type of fault present unambiguously, as will be understood from the description that follows below.

According to one embodiment the vibration measurement includes a radial vibration parameter measurement.

According to one embodiment the vibration measurement includes a tangential vibration parameter measurement.

According to one embodiment the step of obtaining comprises obtaining vibration measurements from a plurality of end winding sensors arranged at a first axial position along the circumference of the end winding thereby obtaining a circumferential magnitude distribution of a vibration parameter.

One embodiment comprises performing a frequency transformation of the circumferential magnitude distribution of the vibration parameter to obtain a frequency spectrum of the circumferential magnitude distribution of the vibration parameter, and comparing the frequency spectrum of the circumferential magnitude distribution of the vibration parameter with reference frequency spectra of circumferential magnitude distribution of the vibration parameter, wherein the determining of whether a fault condition is present in the active shaft region of the electrical machine is further based on the comparison between the frequency spectrum of the circumferential magnitude distribution of the vibration parameter and the reference frequency spectra of the circumferential magnitude distribution of the vibration parameter.

For certain faults a frequency spectrum of a vibration measurement will not unambiguously allow determination of a fault condition. By means of the additional information obtained from the frequency spectra of circumferential magnitude distribution of the vibration parameter unambiguous fault condition diagnostics may however be provided.

According to one embodiment the determining involves identifying the type of fault condition further based on a match with a reference frequency spectrum of the circumferential magnitude distribution of the vibration parameter of a particular fault condition.

According to one embodiment some of the end winding sensors are arranged at a distal end portion of the end winding, distal with respect to the stator of the electrical machine. Vibrations become more prevalent at the distal end portion, or nose portion, of the end winding. By means of end winding sensor placement in this region, better measurement sensitivity may be obtained.

According to one embodiment a frequency component in the frequency spectrum having a magnitude greater than a threshold value at a natural resonance frequency of the electrical machine indicates a dynamic eccentricity fault. This threshold value may for example be twice the amplitude of the corresponding frequency component of a healthy frequency spectrum.

The natural frequencies of the end-winding are pre-decided against different mode shapes of interest. However, these frequencies shift marginally with subsequent mechanical and thermal ageing. With a clear knowledge of historical natural frequencies, the electro-magnetic forces can excite the corresponding signatures in close vicinity, demonstrating an impending resonance, compared to excitation frequencies without any natural frequency in the vicinity.

According to one embodiment a frequency component in the frequency spectrum having a magnitude greater than a threshold value at twice the supply frequency indicates an inter-turn stator short circuit fault. This threshold value may for example be twice the amplitude of the corresponding frequency component of a healthy frequency spectrum.

According to one embodiment a plurality of distinct groups of frequency components present in the frequency spectra of the circumferential magnitude distribution of the vibration parameter indicates a static eccentricity fault.

According to a second aspect of the present disclosure there is provided a diagnostics system arranged to determine fault conditions in an electrical machine by means of end winding vibration measurements, comprising a storage module comprising computer-executable components, and processing circuitry, wherein the computer-executable components causes the diagnostics system to perform the method according to the first aspect when executed by the processing circuitry.

According to a third aspect of the present disclosure there is provided a system comprising a plurality of end winding sensors configured to measure vibrations of an end winding of the stator of an electrical machine, and a diagnostics system according to the second aspect, arranged to be connected to the plurality of end winding sensors.

The electrical machine has a stator, a rotor and an end winding, wherein a subset of the end winding sensors are arranged at a distal end portion of the end winding with respect to the stator, distributed along the circumference of the end winding.

Generally, all terms used in the claims are to be interpreted according to their ordinary meaning in the technical field, unless explicitly defined otherwise herein.

### BRIEF DESCRIPTION OF THE DRAWINGS

The specific embodiments of the inventive concept will now be described, by way of example, with reference to the accompanying drawings, in which:
Fig. 1 shows a block diagram of an example of a diagnostics system for determining fault conditions of an electrical machine by means of end winding vibration measurements;
Fig. 2 shows a perspective view of an example of an end winding;
Figs 3a and 3b show a side view of an electrical machine including an end winding and a perspective view of a model of the end winding including end winding sensors, respectively;
Figs 4a and 4b show a method of determining fault conditions of an electrical machine by means of end winding measurements;
Fig. 5 is an example of end winding measurements in the time domain, in particular total displacement of an end winding sensor measured at different locations on the end winding by different end winding sensors;
Figs 6a-6c show frequency spectra during healthy conditions and various fault conditions; and
Figs 7a-7d show circumferential radial displacement of a plurality of end winding sensors arranged along the circumference of the end winding both in the time domain and in the frequency domain.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

The present disclosure relates to a method of determining fault conditions in an electrical machine by means of end winding vibration measurements. The electrical machine is an electrical rotating machine, such as a motor or a generator. The electrical machine may be a synchronous or an asynchronous electrical machine.

The fault conditions referred to here are fault conditions of the active shaft region of the electrical machine and not of the end winding itself. The active shaft region, also referred to as active shaft length or rotor region, is defined by the length of the electrical machine where electromagnetic interaction between the rotor and the stator of the electrical machine is present. The active region hence includes the active part of the rotor as well as the stator itself.

Fault conditions of the active shaft region appear in the frequency spectrum of the vibration measurements obtained from the end winding sensors, which enable fault condition diagnostics outside the active shaft region. Hereto, fault conditions attributable to the active shaft region, such as eccentricity faults and inter turn short circuit faults may be diagnosed based on vibration measurements of the end windings. Diagnostics may be provided by analysis of the vibration measurements in the frequency domain by frequency transforming the vibration measurements, and comparing the frequency spectra thus obtained with reference frequency spectra, each such reference frequency spectrum being a reference fault frequency spectrum of a particular fault. Each fault hence has a signature frequency spectrum.

For certain faults, the reference frequency spectra do not contain enough information to be able to unambiguously determine whether a fault condition is present or to provide an identification of a certain type of fault. In this case, vibration measurements from a plurality of end winding sensors arranged in essentially one radial plane along the circumference of the end winding can provide auxiliary information. These vibration measurements of end winding sensors arranged in one radial plane along the circumference of the end winding provide vibration parameter information along the circumference in the radial plane in question. Frequency transforming such vibration measurements results in a frequency spectrum of circumferential magnitude distribution of the vibration parameter. Comparison of the frequency spectrum of circumferential magnitude distribution of the vibration parameter with reference frequency spectra of circumferential magnitude distribution of the vibration parameter may provide unambiguity of the previously ambiguous result, and a fault condition may thus be determined.

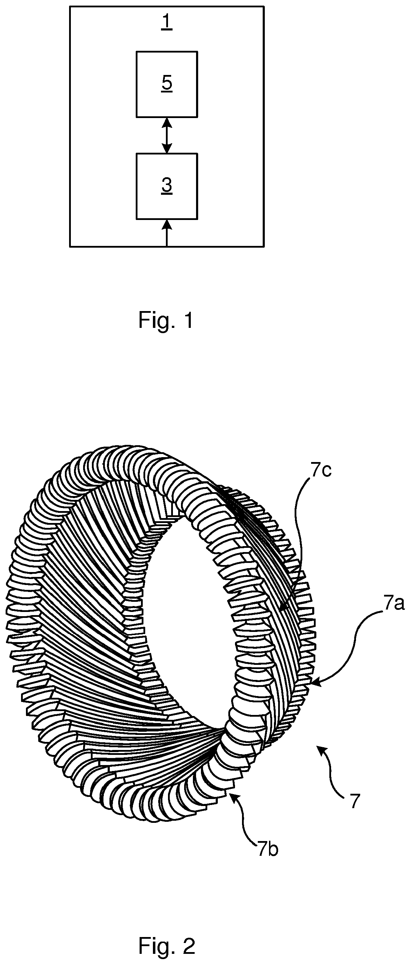

With reference to Fig. 1 an example of a diagnostics system 1 is depicted. The diagnostics system 1 is configured to determine a fault condition in an electrical machine. The diagnostics system 1 is configured to receive vibration measurements from end winding sensors and to determine whether a fault condition is present in the electrical machine based on the vibration measurements. The vibration measurements are measurements of a vibration parameter. The vibration parameter may be one of displacement, velocity and acceleration. In either case, the vibration parameter may be a radial vibration parameter, an axial vibration parameter, a tangential vibration parameter or a total vibration parameter. The total vibration parameter is based on the radial vibration parameter, the axial vibration parameter and the tangential vibration parameter.

The diagnostics system 1 includes processing circuitry 3 and a storage module 5. The processing circuitry 3 is operatively connected to the storage module 5. The processing circuitry 3 uses any combination of one or more of a suitable central processing unit (CPU), multiprocessor, microcontroller, digital signal processor (DSP), application specific integrated circuit (ASIC), field programmable gate arrays (FPGA) etc., capable of executing any herein disclosed operations.

The storage module 5 comprises computer-executable components which when executed by the processing circuitry 3 causes the diagnostics system 1 to perform the method disclosed herein, and which will be described in more detail in the following.

According to one variation the storage module 5 may store the reference frequency spectra and reference frequency spectra of circumferential magnitude distribution of a vibration parameter. According to another variation, the diagnostics system may be configured to receive the reference frequency spectra and reference frequency spectra of circumferential magnitude distribution of the vibration parameter from an external source e.g. an external database by means of wired of wireless communication when needed, instead of being stored in the storage module.

Fig. 2 depicts an example of an end winding 7. For the sake of simplicity, the rest of the electrical machine, e.g. the stator is not shown in this figure. End winding 7 is formed by a coil which is drawn through the stator a plurality of times. In particular, the coil is taken out from and routed back into the stator a plurality of times whereby the configuration shown in Fig. 2 is formed. The end winding 7 has a proximal end portion 7a, which is arranged closest to the stator, a distal end portion 7b with respect to the stator, and an intermediate portion 7c arranged between the proximal end portion 7a and the distal end portion 7b. The distal end portion 7b forms the nose of the end winding 7.

It has been found that vibrations of end winding 7 increase in amplitude in the distal direction, i.e. in a direction from the proximal end portion 7a towards the distal end portion 7b. Hereto, end winding sensors are preferably arranged on the distal end portion 7b. This increases the sensitivity of vibration measurements. A plurality of end winding sensors arranged on the distal end portion 7b may be arranged in essentially one radial plane, distributed along the circumference of the distal end portion 7b. End winding sensors may also be arranged on the intermediate portion 7c and/or on the proximal end portion 7a.

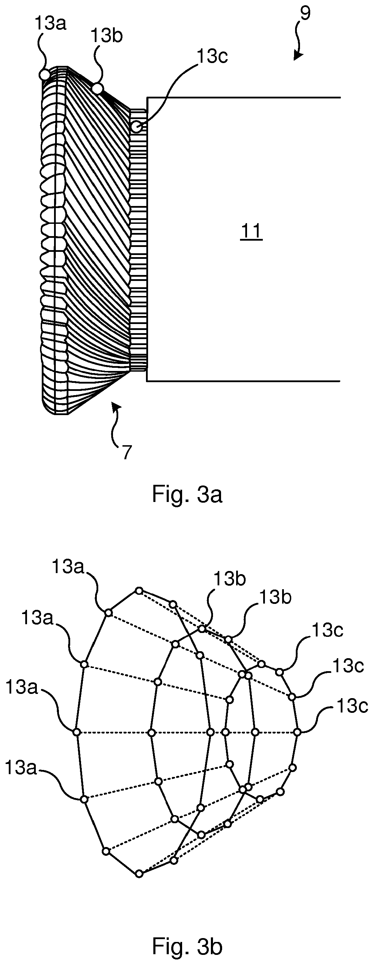

Fig. 3a shows a portion of an electrical machine 9 including the end winding 7 and a stator 11. Placements of end winding sensors 13a, 13b and 13c can be seen on the distal end portion 7b, the intermediate portion 7c and the proximal end portion 7a, respectively. In Fig. 3b, it can be seen that a plurality of end winding sensors 13a is arranged in one radial plane, distributed along the circumference of the distal end portion 7b. Similarly, end winding sensors 13b and 13c are distributed in respective radial planes in the intermediate portion 7c and the proximal end portion 7a of the end winding 7.

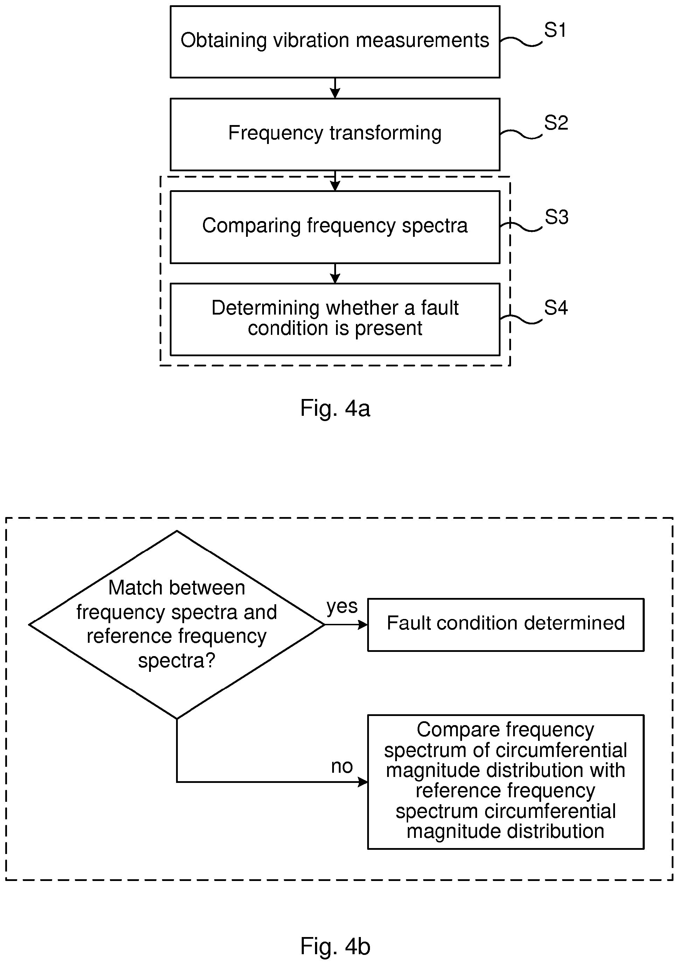

With reference to Figs 4a and 4b, a method of determining fault conditions in an electrical machine by means of end winding vibration measurements will now be explained. This method may be carried out by the diagnostics system 1.

In a step S₁ vibration measurements are obtained from the end winding sensors 13a-13c. These vibration measurements are obtained by the diagnostics system 1, in particular the processing circuitry 3.

Here, each end winding sensor 13a-13c may provide measurements of one or more vibration parameters, e.g. one of, some of, or all of radial displacement, axial displacement and tangential displacement. Moreover, step S₁ may include obtaining the total vibration parameter of each or some of the end winding sensors 13a-13c. The total vibration parameter is determined by the ℓ²-norm of the radial vibration parameter, the axial vibration parameter and tangential vibration parameter i.e. the vector length of these three vibration parameters.

In a step S2 the vibration measurements are frequency transformed to the frequency domain by means of the processing circuitry 3. Thus, each vibration measurement obtained from an end winding sensor is transformed into the frequency domain, whereby a plurality of frequency spectra is obtained. The frequency transformation is made by means of for example a Fourier transformer such as a Discrete Fourier Transform (DFT), computed by for example a Fast Fourier Transform (FFT).

In a step S3, the frequency spectra are compared with reference frequency spectra. The reference frequency spectra are preferably reference fault frequency spectra, each frequency spectrum of the frequency spectra describing or showing the signature of a specific fault. Each frequency spectrum is compared to reference frequency spectra of the same type; the frequency spectrum obtained from a certain vibration parameter type, e.g. radial or tangential displacement, measured by a certain end winding sensor is compared to corresponding reference frequency spectra, i.e. of the same vibration parameter type and obtained from the same position on the end winding that the current frequency spectrum has been obtained from.

The reference frequency spectra of various fault conditions may be obtained from modelling faults of the particular electrical machine or they may be obtained empirically.

In a step S4 it is determined whether a fault condition is present in the active shaft region of the electrical machine based on the comparison in step S3 between the frequency spectra and the reference frequency spectra.

In the event that a match can be found between a frequency spectrum and a reference frequency spectrum, it is determined that a fault condition is present. Moreover, the type of fault condition is also determined based on the classification of the matching reference frequency spectrum, i.e. the fault condition associated with the matching reference frequency spectrum.

In the event that no match can be found or in case the frequency spectra do not contain any defining frequency components that clearly distinguish from healthy conditions, circumferential magnitude distribution of a vibration parameter from sensors arranged in the same radial plane along the circumference of the end winding 7 can be utilised for further evaluation. Also in this case, the vibration parameter may be one of a radial vibration parameter, axial vibration parameter, tangential vibration parameter and/or total vibration parameter. For one circumferential magnitude distribution of a vibration parameter measurement it is however the same vibration parameter utilised for each end winding sensor arranged in one radial plane, e.g. only the radial displacement or only the axial displacement is in this case used for all end winding sensors involved. In this case, step S4 of determining is thus further based on the comparison between the frequency spectrum of the circumferential magnitude distribution of a vibration parameter and reference spectra of the circumferential magnitude distribution of a vibration parameter. Here, the reference spectra of circumferential magnitude distribution of a vibration parameter are reference fault frequency spectra of the circumferential magnitude distribution of a vibration parameter, each frequency spectrum within the frequency spectra being associated with a respective specific fault condition.

In this manner, a fault condition present in the active shaft region of an electrical machine can be detected and the type of fault condition may be determined.

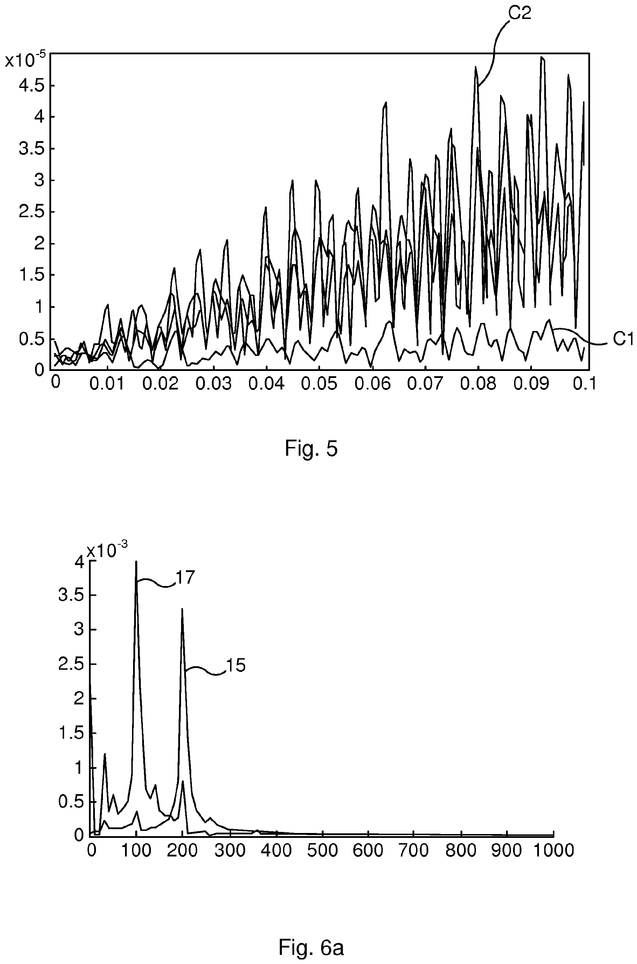

With reference to Figs. 5 to 7d, examples of fault condition diagnostics by means of end winding vibrations according to the present method will now be described.

Fig. 5 shows measurements by end winding sensors of total displacement measured at different axial locations of the end winding 7. According to the example in Fig. 5, a dynamic eccentricity fault occurs at time o and it can be seen that the vibrations increase in amplitude from this instance. Curve C1 shows the total displacement measured by an end winding sensor 13c arranged on the proximal end portion 7a, while curve C2 shows the total displacement measured by and end winding sensor 13a arranged on the distal end portion 7b of the end winding 7. The remaining two curves show corresponding measurements on the intermediate portion 7c of the end winding 7. As can be seen, the amplitude of the vibration measurements increases the further the end winding sensors are arranged from the stator in the distal direction.

Vibration measurements of the type shown in Fig. 5 are frequency transformed to the frequency domain for further analysis in step S2 described above. Fig. 6a a shows the frequency spectrum 15 of radial displacement vibration measurements at the distal end portion during healthy conditions of the electrical machine, and the frequency spectrum 17 of the same vibration measurements in the presence of an inter-turn short circuit fault. It can here be seen that a prominent frequency component appears at twice the supply frequency, at 100 Hz, with the supply frequency being 50 Hz. There is a frequency component present at twice the supply frequency already during healthy conditions, but this frequency component is far more prominent during an inter-turn short circuit fault. By detecting that the frequency component at twice the supply frequency has a magnitude greater than a threshold value, e.g. twice the magnitude of the frequency component during healthy conditions, for example four times greater than the magnitude of the frequency component during healthy conditions, it may be determined that an inter-turn short circuit fault is present. Thus, when in the step S3 of comparison frequency spectrum 17 is matched with the corresponding reference frequency spectrum, it is determined in step S4 that an inter-turn short circuit fault is present.

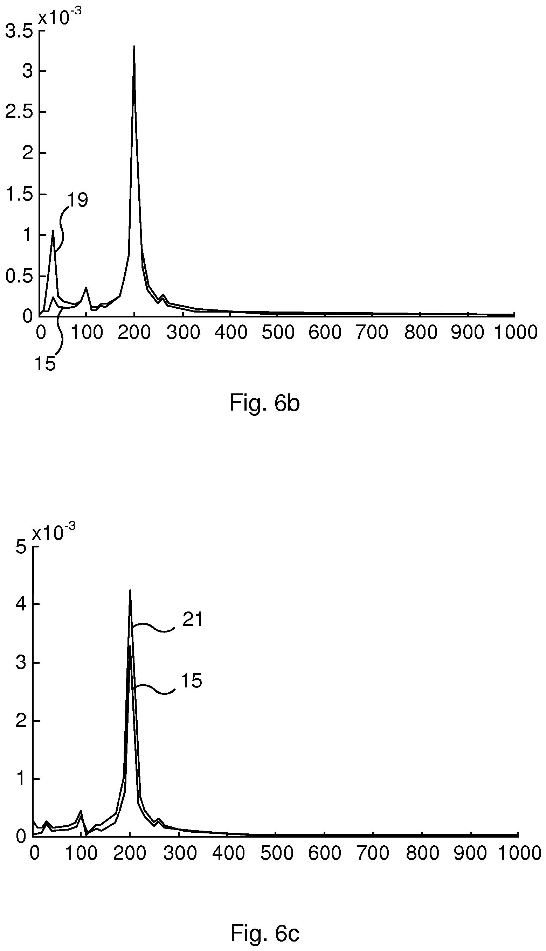

In Fig. 6b the same healthy frequency spectrum 15 is shown as in Fig. 6a. This time, however, the frequency spectrum 19 in the presence of a dynamic eccentricity fault is also shown. As can be seen, a prominent frequency component is present at about 30 Hz, which is a natural resonance frequency of the electrical machine upon which the present example is based. A natural resonance frequency is a frequency at which the electrical machine self-oscillates. This natural resonance frequency has been reinforced by the dynamic eccentricity fault. To this end, it can be concluded that a dynamic eccentricity fault is present in case a prominent frequency component is present at or approximately at the natural resonance frequency of the electrical machine. In particular, it may be determined that a dynamic eccentricity is present in case a frequency component has a magnitude greater than a threshold value. This threshold value may for example be twice or three times the magnitude of the corresponding frequency component during healthy conditions.

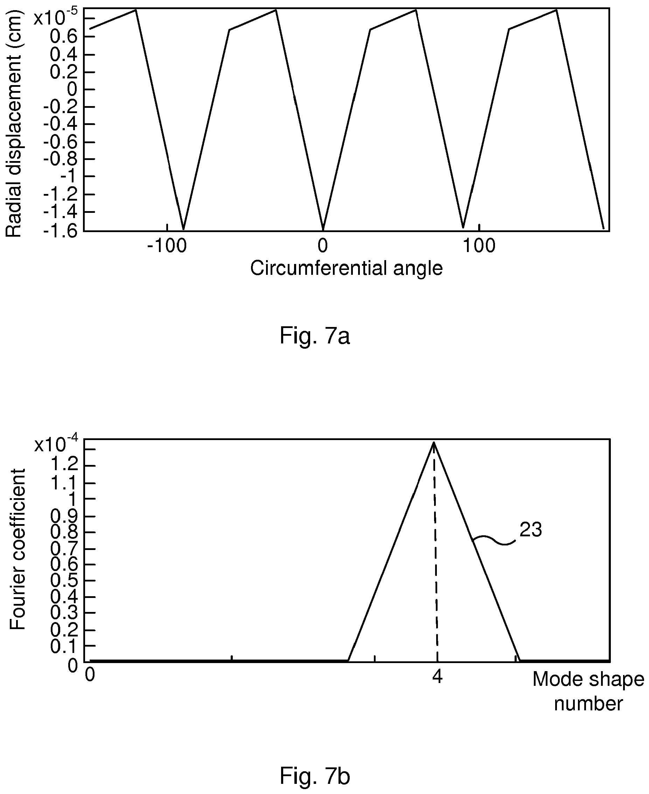

Fig. 6c shows the healthy frequency spectrum 15 as well as the corresponding frequency spectrum 21 during a static eccentricity fault. Although the frequency component at 200 Hz is greater in magnitude than during healthy conditions, it cannot be unambiguously determined what fault condition is present. In this case, the circumferential magnitude distribution of a vibration parameter measured by a plurality of sensors arranged in the same or essentially the same radial plane along the circumference of the end winding 7 may be utilised to determine the fault condition. The example in Fig. 7a shows a vibration measurement in the form of instantaneous circumferential radial displacement measured by the end winding sensors during healthy conditions, with the x-axis indicating the angle along the circumference. According to the example in Fig. 7a, there are twelve end winding sensors along the circumference in the radial plane in question. Furthermore, according to the example, each end winding sensor measures the radial displacement and this is plotted as a function of the angle along the circumference. Every point where the curve changes inclination corresponds to an end winding sensor measurement. The frequency transform, in this example the Fourier Transform, is shown in fig. 7b, with the x-axis indicating the mode shape number. A mode shape is one of the plurality of mode shapes obtainable by oscillation of the end winding 7, measured by the end winding sensors arranged in the same radial plane.

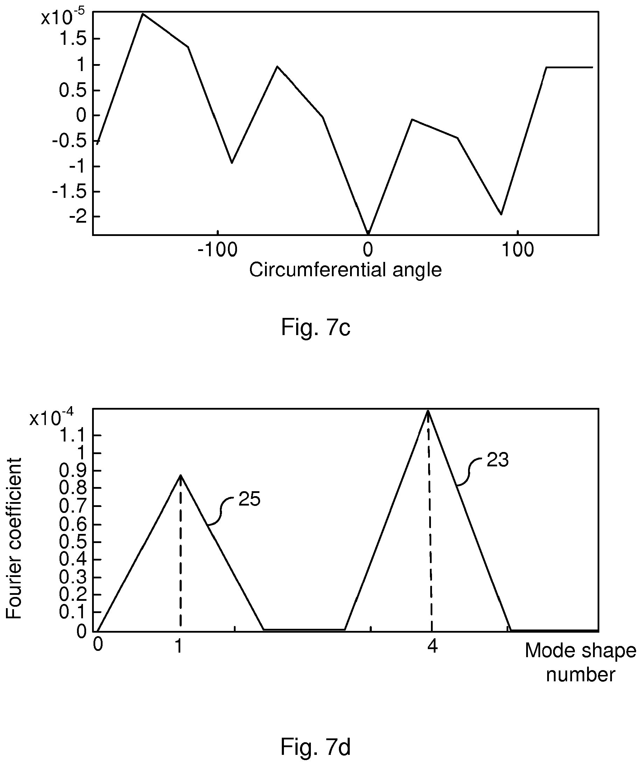

Fig. 7c shows the instantaneous circumferential radial displacement measured by the end winding sensors during a static eccentricity condition. Fig. 7d shows the corresponding frequency transform, in this example the Fourier Transform, of the instantaneous circumferential radial displacement in Fig. 7c. As can be seen, the frequency spectrum shown in Fig. 7d differs from the healthy frequency spectrum shown in Fig. 7b where only one group of frequency components 23 is present. During the static eccentricity fault condition another distinct group of frequency components 25 is also present. In particular, two mode shapes are present in the spectrum instead of only one. It may hereby be determined that a static eccentricity fault is present in the active shaft region.

The inventive concept has mainly been described above with reference to a few examples. However, as is readily appreciated by a person skilled in the art, other embodiments than the ones disclosed above are equally possible within the scope of the inventive concept, as defined by the appended claims. For example, according to one variation there may be only one end winding sensor present on the end winding; in this case not all of the above fault conditions may be detected, e.g. a static eccentricity fault would not be detectable.

## Claims

1. A method of determining fault conditions in a rotating electrical machine (9) comprising a rotor and a stator (11) by means of end winding vibration measurements, wherein the method comprises:
obtaining (S1) a vibration measurement from an end winding sensor (13a, 13b, 13c) arranged on an end winding (7) of the stator (11) of the electrical machine (3), and configured to measure vibrations of the end winding (7),
frequency transforming (S2) the vibration measurement to obtain a frequency spectrum (15, 17, 19, 21) of the vibration measurement,
comparing (S3) the frequency spectrum with reference frequency spectra (17, 19, 21), and
determining (S4) whether a fault condition is present in an active shaft region of the electrical machine (9) based on the comparison between the frequency spectrum (15, 17, 19, 21) and the reference frequency spectra (17, 19, 21), wherein the active shaft region is defined by the length of the electrical machine where electromagnetic interaction between the rotor and the stator of the electrical machine is present.

2. The method as claimed in claim 1, wherein the reference frequency spectra (17, 19, 21) includes reference fault frequency spectra related to faults in the active shaft region of the electrical machine (9), wherein the determining (S4) involves identifying the type of fault based on a match with a reference frequency spectrum (17, 19, 21) of a particular fault condition.

3. The method as claimed in claim 1 or 2, wherein the vibration measurement includes a radial vibration parameter measurement.

4. The method as claimed in any of the preceding claims, wherein the vibration measurement includes a tangential vibration parameter measurement.

5. The method as claimed in any of the preceding claims, wherein the step of obtaining comprises obtaining vibration measurements from a plurality of end winding sensors arranged at a first axial position along the circumference of the end winding (7) thereby obtaining a circumferential magnitude distribution of a vibration parameter.

6. The method as claimed in claim 5, comprising:
performing a frequency transformation of the circumferential magnitude distribution of the vibration parameter to obtain a frequency spectrum of the circumferential magnitude distribution of the vibration parameter (23, 25), and
comparing the frequency spectrum of the circumferential magnitude distribution of the vibration parameter (23, 25) with reference frequency spectra of circumferential magnitude distribution of the vibration parameter (25),
wherein the determining of whether a fault condition is present in the active shaft region of the electrical machine (9) is further based on the comparison between the frequency spectrum of the circumferential magnitude distribution of the vibration parameter (23, 25) and the reference frequency spectra of the circumferential magnitude distribution of the vibration parameter (25).

7. The method as claimed in claim 6, wherein the determining involves identifying the type of fault condition further based on a match with a reference frequency spectrum of the circumferential magnitude distribution of the vibration parameter (25) of a particular fault condition.

8. The method as claimed in any of the preceding claims, wherein some of the end winding sensors (13a) are arranged at a distal end portion of the end winding (7), distal with respect to the stator (11) of the electrical machine (9).

9. The method as claimed in any of the preceding claims, wherein a frequency component in the frequency spectrum having a magnitude greater than a threshold value at a natural resonance frequency of the electrical machine (9) indicates a dynamic eccentricity fault.

10. The method as claimed in any of the preceding claims, wherein a frequency component in the frequency spectrum having a magnitude greater than a threshold value at twice the supply frequency indicates an inter-turn stator short circuit fault.

11. The method as claimed in any of claims 6-10, wherein a plurality of distinct groups of frequency components present in the frequency spectrum of the circumferential magnitude distribution of the vibration parameter (25) indicates a static eccentricity fault.

12. A diagnostics system (1) arranged to determine fault conditions in a rotating electrical machine (9) comprising a rotor and a stator (11) by means of end winding vibration measurements, comprising:
a storage module (5) comprising computer-executable components, and processing circuitry (3),
wherein the computer-executable components causes the diagnostics system (1) to perform the method of any of claims 1-11 when executed by the processing circuitry (3).

13. A system comprising:
a plurality of end winding sensors (13a, 13b, 13c) configured to measure vibrations of an end winding (7) of a stator (11) of an electrical machine (9), and
a diagnostics system (1) according to claim 12, arranged to be connected to the plurality of end winding sensors (13a, 13b, 13c).

14. The system as claimed in claim 13, comprising an electrical machine (9) having a stator (11), a rotor and an end winding (7), wherein a subset of the end winding sensors (13a) are arranged at a distal end portion (7b) of the end winding (7) with respect to the stator (11), distributed along the circumference of the end winding (7).

## Patentansprüche

1. Verfahren zum Bestimmen von Fehlerzuständen in einer rotierenden elektrischen Maschine (9), die einen Rotor und einen Stator (11) umfasst, mittels Wickelkopfschwingungsmessungen, wobei das Verfahren Folgendes umfasst:
Erhalten (S1) einer Schwingungsmessung von einem Wickelkopffühler (13a, 13b, 13c), der auf einem Wickelkopf (7) des Stators (11) der elektrischen Maschine (3) angeordnet und konfiguriert ist, um Schwingungen des Wickelkopfs (7) zu messen,
Frequenzumsetzen (S2) der Schwingungsmessung, um ein Frequenzspektrum (15, 17, 19, 21) der Schwingungsmessung zu erhalten,
Vergleichen (S3) des Frequenzspektrums mit Bezugsfrequenzspektren (17, 19, 21) und
Bestimmen (S4), ob in einem stromführenden Wellenbereich der elektrischen Maschine (9) ein Fehlerzustand vorliegt, basierend auf dem Vergleich zwischen dem Frequenzspektrum (15, 17, 19, 21) und den Bezugsfrequenzspektren (17, 19, 21), wobei der stromführende Wellenbereich von der Länge der elektrischen Maschine, wo zwischen dem Rotor und dem Stator der elektrischen Maschine eine elektromagnetische Wechselwirkung erfolgt, definiert wird.

2. Verfahren nach Anspruch 1, wobei die Bezugsfrequenzspektren (17, 19, 21) Bezugsfehlerfrequenzspektren bezüglich Fehlern im stromführenden Wellenbereich der elektrischen Maschine (9) enthalten, wobei das Bestimmen (S4) das Identifizieren des Fehlertyps basierend auf einer Übereinstimmung mit einem Bezugsfrequenzspektrum (17, 19, 21) eines jeweiligen Fehlerzustands einschließt.

3. Verfahren nach Anspruch 1 oder 2, wobei die Schwingungsmessung eine Radialschwingungsparametermessung enthält.

4. Verfahren nach einem der vorhergehenden Ansprüche, wobei die Schwingungsmessung eine Tangentialschwingungsparametermessung enthält.

5. Verfahren nach einem der vorhergehenden Ansprüche, wobei der Schritt des Erhaltens das Erhalten von Schwingungsmessungen von einer Vielzahl von Wickelkopffühlern, die an einer ersten Axialposition entlang des Umfangs des Wickelkopfs (7) angeordnet sind, wodurch eine Umfangsbetragsverteilung eines Schwingungsparameters erhalten wird, umfasst.

6. Verfahren nach Anspruch 5, umfassend:
Durchführen einer Frequenzumsetzung der Umfangsbetragsverteilung des Schwingungsparameters, um ein Frequenzspektrum der Umfangsbetragsverteilung des Schwingungsparameters (23, 25) zu erhalten, und
Vergleichen des Frequenzspektrums der Umfangsbetragsverteilung des Schwingungsparameters (23, 25) mit Bezugsfrequenzspektren einer Umfangsbetragsverteilung des Schwingungsparameters (25), wobei das Bestimmen, ob im stromführenden Wellenbereich der elektrischen Maschine (9) ein Fehlerzustand vorliegt, ferner auf dem Vergleich zwischen dem Frequenzspektrum der Umfangsbetragsverteilung des Schwingungsparameters (23, 25) und den Bezugsfrequenzspektren der Umfangsbetragsverteilung des Schwingungsparameters (25) basiert.

7. Verfahren nach Anspruch 6, wobei das Bestimmen das Identifizieren des Fehlerzustandstyps ferner basierend auf einer Übereinstimmung mit einem Bezugsfrequenzspektrum der Umfangsbetragsverteilung des Schwingungsparameters (25) eines jeweiligen Fehlerzustands einschließt.

8. Verfahren nach einem der vorhergehenden Ansprüche, wobei einige der Wickelkopffühler (13a) an einem distalen Endabschnitt des Wickelkopfs (7), der mit Bezug auf den Stator (11) der elektrischen Maschine (9) distal ist, angeordnet sind.

9. Verfahren nach einem der vorhergehenden Ansprüche, wobei eine Frequenzkomponente im Frequenzspektrum, deren Betrag bei einer Eigenresonanzfrequenz der elektrischen Maschine (9) größer als ein Schwellenwert ist, einen Fehler einer dynamischen Exzentrizität anzeigt.

10. Verfahren nach einem der vorhergehenden Ansprüche, wobei eine Frequenzkomponente im Frequenzspektrum, deren Betrag bei der doppelten Netzfrequenz größer als ein Schwellenwert ist, einen Stator-Windungskurzschlussfehler anzeigt.

11. Verfahren nach einem der Ansprüche 6-10, wobei eine Vielzahl einzelner Gruppen von Frequenzkomponenten, die im Frequenzspektrum der Umfangsbetragsverteilung des Schwingungsparameters (25) vorhanden sind, einen Fehler einer statischen Exzentrizität anzeigt.

12. Diagnosesystem (1), das zum Bestimmen von Fehlerzuständen in einer rotierenden elektrischen Maschine (9), die einen Rotor und einen Stator (11) umfasst, mittels Wickelkopfschwingungsmessungen angeordnet ist, umfassend:
ein Speichermodul (5), das computerausführbare Komponenten umfasst, und
eine Verarbeitungsschaltung (3),
wobei die computerausführbaren Komponenten bewirken, dass das Diagnosesystem (1) das Verfahren nach einem der Ansprüche 1-11 durchführt, wenn sie durch die Verarbeitungsschaltung (3) ausgeführt werden.

13. System, umfassend:
eine Vielzahl von Wickelkopffühlern (13a, 13b, 13c), die konfiguriert sind, um Schwingungen eines Wickelkopfs (7) eines Stators (11) einer elektrischen Maschine (9) zu messen, und
ein Diagnosesystem (1) nach Anspruch 12, das so angeordnet ist, dass es sich mit der Vielzahl von Wickelkopffühlern (13a, 13b, 13c) verbinden lässt.

14. System nach Anspruch 13, das eine elektrische Maschine (9), die einen Stator (11), einen Rotor und einen Wickelkopf (7) aufweist, umfasst, wobei eine Teilmenge der Wickelkopffühler (13a) an einem distalen Endabschnitt (7b) des Wickelkopfs (7) mit Bezug auf den Stator (11) angeordnet und entlang des Umfangs des Wickelkopfs (7) verteilt ist.

## Revendications

1. Procédé de détermination d'états de défaut dans une machine électrique tournante (9) comportant un rotor et un stator (11) au moyen de mesures de vibrations d'enroulement d'extrémité, le procédé comportant les étapes consistant à :
obtenir (S1) une mesure de vibrations à partir d'un capteur (13a, 13b, 13c) d'enroulement d'extrémité disposé sur un enroulement (7) d'extrémité du stator (11) de la machine électrique (3), et configuré pour mesurer des vibrations de l'enroulement (7) d'extrémité, transformer en fréquence (S2) la mesure de vibrations pour obtenir un spectre (15, 17, 19, 21) de fréquences de la mesure de vibrations,
comparer (S3) le spectre de fréquences avec des spectres (17, 19, 21) de fréquences de référence, et
déterminer (S4) si un état de défaut est présent dans une région active d'arbre de la machine électrique (9) d'après la comparaison entre le spectre (15, 17, 19, 21) de fréquences et les spectres (17, 19, 21) de fréquences de référence, la région active d'arbre étant défini par la longueur de la machine électrique où une interaction électromagnétique entre le rotor et le stator de la machine électrique est présente.

2. Procédé selon la revendication 1, les spectres (17, 19, 21) de fréquences de référence comprenant des spectres de fréquences de défauts de référence liés à des défauts dans la région active d'arbre de la machine électrique (9), la détermination (S4) faisant intervenir l'identification du type de défaut d'après une concordance avec un spectre (17, 19, 21) de fréquences de référence d'un état de défaut particulier.

3. Procédé selon la revendication 1 ou 2, la mesure de vibrations comprenant une mesure de paramètre de vibrations radiales.

4. Procédé selon l'une quelconque des revendications précédentes, la mesure de vibrations comprenant une mesure de paramètre de vibrations tangentielles.

5. Procédé selon l'une quelconque des revendications précédentes, l'étape d'obtention comportant l'obtention de mesures de vibrations à partir d'une pluralité de capteurs d'enroulement d'extrémité disposés dans une première position axiale le long de la circonférence de l'enroulement (7) d'extrémité, obtenant ainsi une répartition circonférentielle d'amplitude d'un paramètre de vibrations.

6. Procédé selon la revendication 5, comportant les étapes consistant à :
effectuer une transformation de fréquence de la répartition circonférentielle d'amplitude du paramètre de vibrations pour obtenir un spectre de fréquences de la répartition circonférentielle d'amplitude du paramètre (23, 25) de vibrations, et
comparer le spectre de fréquences de la répartition circonférentielle d'amplitude du paramètre (23, 25) de vibrations avec des spectres de fréquences de référence de répartition circonférentielle d'amplitude du paramètre (25) de vibrations,
la détermination selon laquelle un état de défaut est présent ou non dans la région active d'arbre de la machine électrique (9) étant en outre basée sur la comparaison entre le spectre de fréquences de la répartition circonférentielle d'amplitude du paramètre (23, 25) de vibrations et les spectres de fréquences de référence de la répartition circonférentielle d'amplitude du paramètre (25) de vibrations.

7. Procédé selon la revendication 6, la détermination faisant intervenir l'identification du type d'état de défaut, basée en outre sur une concordance avec un spectre de fréquences de référence de la répartition circonférentielle d'amplitude du paramètre (25) de vibrations d'un état de défaut particulier.

8. Procédé selon l'une quelconque des revendications précédentes, certains des capteurs d'enroulement d'extrémité (13a) étant disposés au niveau d'une partie d'extrémité distale de l'enroulement (7) d'extrémité, distale par rapport au stator (11) de la machine électrique (9).

9. Procédé selon l'une quelconque des revendications précédentes, une composante de fréquence dans le spectre de fréquences qui présente une amplitude supérieure à une valeur seuil à une fréquence de résonance naturelle de la machine électrique (9) indiquant un défaut d'excentricité dynamique.

10. Procédé selon l'une quelconque des revendications précédentes, une composante de fréquence dans le spectre de fréquences qui présente une amplitude supérieure à une valeur seuil au double de la fréquence d'alimentation indiquant un défaut de court-circuit inter-spires de stator.

11. Procédé selon l'une quelconque des revendications 6 à 10, une pluralité de groupes distincts de composantes de fréquence présents dans le spectre de fréquences de la répartition circonférentielle d'amplitude du paramètre (25) de vibrations indiquant un défaut d'excentricité statique.

12. Système (1) de diagnostics disposé pour déterminer des états de défaut dans une machine électrique tournante (9) comportant un rotor et un stator (11) au moyen de mesures de vibrations d'enroulement d'extrémité, comportant :
un module (5) de stockage comportant des composants exécutables par ordinateur, et
une circuiterie (3) de traitement,
les composants exécutables par ordinateur amenant le système (1) de diagnostics à réaliser le procédé selon l'une quelconque des revendications 1 à 11 lorsqu'ils sont exécutés par la circuiterie (3) de traitement.

13. Système comportant :
une pluralité de capteurs (13a, 13b, 13c) d'enroulement d'extrémité configurés pour mesurer des vibrations d'un enroulement (7) d'extrémité d'un stator (11) d'une machine électrique (9), et
un système (1) de diagnostics selon la revendication 12, disposé pour être relié à la pluralité de capteurs (13a, 13b, 13c) d'enroulement d'extrémité.

14. Système selon la revendication 13, comportant une machine électrique (9) dotée d'un stator (11), d'un rotor et d'un enroulement (7) d'extrémité, un sous-ensemble des capteurs (13a) d'enroulement d'extrémité étant disposé au niveau d'une partie (7b) d'extrémité distale de l'enroulement (7) d'extrémité par rapport au stator (11), réparti suivant la circonférence de l'enroulement (7) d'extrémité.
